# EUROPEAN PATENT SPECIFICATION

(11) **EP 3 848 962 B1**
(45) Date of publication and mention of the grant of the patent: **04.06.2025**
(21) Application number: 20213349.2
(22) Date of filing: 11.12.2020
(51) Int. Cl.: H01L 23/498, H01L 23/538

(54) **SEMICONDUCTOR PACKAGE HAVING RE-DISTRIBUTION LAYER STRUCTURE ON SUBSTRATE COMPONENT**
HALBLEITERGEHÄUSE MIT UMVERTEILUNGSSCHICHTSTRUKTUR AUF EINER SUBSTRATKOMPONENTE
BOÎTIER À SEMI-CONDUCTEUR DOTÉ D'UNE STRUCTURE DE COUCHE DE REDISTRIBUTION SUR UN COMPOSANT DE SUBSTRAT

(30) Priority: 10.01.2020 US 202062959336 P; 03.12.2020 US 202017111456
(43) Date of publication of application: 14.07.2021
(73) Proprietor: MEDIATEK INC., Hsin-Chu 300 (TW)
(72) Inventor: TSAI, Yi-Lin, 30078 Hsinchu City (TW); CHIU, Shih-Chao, 30078 Hsinchu City (TW); HSU, Wen-Sung, 30078 Hsinchu City (TW); CHIU, Sang-Mao, 30078 Hsinchu City (TW); CHEN, Chi-Yuan, 30078 Hsinchu City (TW); HSU, Yao-Pang, 30078 Hsinchu City (TW)
(74) Representative: Hoefer & Partner Patentanwälte mbB

(56) References cited:
- JP-A- 2001 168 242
- TW-A- 201 505 085
- US-A1- 2001 020 739
- US-A1- 2003 082 846
- US-A1- 2008 265 399
- US-A1- 2011 159 639
- US-A1- 2014 339 706
- US-A1- 2016 118 333
- US-A1- 2017 062 383

## Description

### Cross Reference to Related Applications

This application claims priority from U.S. provisional application No. 62/959,336 filed on January 10, 2020.

### Background

The present disclosure relates generally to the field of semiconductor packaging. In particular, the present disclosure relates to a cost-effective chip on RDL on substrate (CRoS) package and fabrication methods thereof. More particularly, the present invention relates to a semiconductor package according to the pre-characterizing part of the independent claim. Such a semiconductor package is disclosed in documents US 2014/0339706 A1 and US 2003/0082846 A1. A similar semiconductor package is disclosed in documents US 2008/0265399 A1, US 2001/0020739 A1, TW 201 505 085 A, US 2011/0159639 A1, US 2016/0118333 A1 and US 2017/0062383 A1.

Document JP 2001 168242 A discloses encapsulating a component and its solder balls.

Emerging markets are always driving demand for higher performance, higher bandwidth, lower power consumption as well as increasing functionality in mobile applications. Packaging technology has become more challenging and complicated than ever before, driving advance silicon nodes, finer bump pitch as well as finer line width and spacing substrate manufacturing capabilities to satisfy the increasing requirements in semiconductor industry.

Although emerging markets are driving advanced technologies in high performance mobile devices, assembly cost is still the major issue to be addressed. As the substrate cost is always the significant factor in a flip chip package, flip chip assembly with a low cost substrate has become a hot topic in the industry.

A prior art method for forming a semiconductor package generally involves the following steps. First, multiple cored substrate components are mounted on a carrier. Each of the cored substrate components has a plurality of copper pillars disposed on a chip side thereof. Subsequently, the multiple cored substrate components are over-molded and the end surface of each of the plurality of copper pillars is exposed by grinding or polishing. A re-distribution layer (RDL) is then fabricated on the top surface of the molding compound and is electrically coupled to the cored substrate component through the plurality of pillars. Thereafter, multiple integrated circuit (IC) dies are mounted on the RDL.

The above-described prior art has several drawbacks. For example, to compensate the thickness variation of the cored substrate components, an adequate height (>150µm) of the plurality of copper posts is required. However, the tall copper pillars may reduce latency and incur high cost of copper plating. The diameter size of the copper pillars is constrained because of the shear force demand. Further, the design rule of routing is constrained by the positions of the plurality of copper posts and the dimension of each copper post. The RDL may suffer from package warping due to the over-molding process.

### Summary

It is an object of the invention to provide an improved semiconductor package with chip on RDL on substrate (CRoS) configuration in order to solve the above-mentioned prior art problems or shortcomings. A semiconductor package according to the invention is defined in the independent claim. The dependent claims define preferred embodiments thereof.

One aspect of the invention provides a semiconductor package including a substrate component comprising a first surface, a second surface opposite to the first surface, and a sidewall surface extending between the first surface and the second surface; a re-distribution layer (RDL) structure disposed on the first surface and electrically connected to the first surface through first connecting elements comprising solder bumps or balls; a plurality of ball grid array (BGA) balls mounted on the second surface of the substrate component; and at least one integrated circuit die mounted on the RDL structure through second connecting elements.

Preferably, the first surface, the second surface, and the sidewall surface of the substrate component are not covered with an encapsulant.

Preferably, a gap is disposed between the RDL structure and the substrate component.

Preferably, the gap has a standoff height h₃ that is smaller than 100 µm.

Preferably, the gap is filled with an underfill and the connecting elements are surrounded by the underfill.

Preferably, the underfill comprises a non-conductive paste or a non-conductive film.

Preferably, the gap is not filled with an underfill and the first connecting elements are at least partially exposed.

Preferably, the RDL structure comprises dielectric layers, traces in the dielectric layers, bonding pads at a substrate-side surface of the RDL structure for connecting with the substrate component, and re-distributed bonding pads disposed at a chip-side surface of the RDL structure for connecting with the at least one integrated circuit die.

Preferably, the first connecting elements are directly connected to the bonding pads, respectively.

Preferably, the RDL structure has an RDL pitch of line/space (L/S) ≤ 2/2 µm.

A sidewall surface of the RDL structure is aligned with the sidewall surface of the substrate component along a vertical direction.

Another aspect useful to understand the invention provides a semiconductor package including a substrate component comprising a first surface, a second surface opposite to the first surface, and a sidewall surface extending between the first surface and the second surface; an encapsulant covering the second surface and the sidewall surface, wherein the first surface is flush with an upper surface of the encapsulant; a re-distribution layer (RDL) structure disposed directly on the first surface of the substrate component and on the upper surface of the encapsulant; a plurality of ball grid array (BGA) balls mounted on the second surface of the substrate component; and at least one integrated circuit die mounted on the RDL structure through a plurality of connecting elements.

Preferably, the encapsulant is in direct contact with an upper portion of each of the BGA balls.

Preferably, the RDL structure comprises dielectric layers, traces in the dielectric layers, and re-distributed bonding pads disposed at a chip-side surface of the RDL structure for connecting with the at least one integrated circuit die.

Preferably, the RDL structure has an RDL pitch of line/space (L/S) ≤ 2/2 µm.

Another aspect useful to understand the invention provides a semiconductor package including a substrate component comprising a first surface, a second surface opposite to the first surface, and a sidewall surface extending between the first surface and the second surface; an encapsulant covering the first surface, the second surface and the sidewall surface; a re-distribution layer (RDL) structure disposed on an upper surface of the encapsulant and electrically connected to the first surface through first connecting elements comprising solder bumps or balls; a plurality of ball grid array (BGA) balls mounted on the second surface of the substrate component; and at least one integrated circuit die mounted on the RDL structure through a plurality of second connecting elements.

Preferably, the first surface is not flush with an upper surface of the encapsulant.

Preferably, the encapsulant is in direct contact with an upper portion of each of the BGA balls.

Preferably, the RDL structure comprises dielectric layers, traces in the dielectric layers, and re-distributed bonding pads disposed at a chip-side surface of the RDL structure for connecting with the at least one integrated circuit die.

Preferably, the RDL structure has an RDL pitch of line/space (L/S) ≤ 2/2 µm.

These and other objectives of the present invention will no doubt become obvious to those of ordinary skill in the art after reading the following detailed description of the preferred embodiment that is illustrated in the various figures and drawings.

### Brief Description of the Drawings

The accompanying drawings are included to provide a further understanding of the invention and are incorporated in and constitute a part of this specification. The drawings illustrate embodiments of the invention and, together with the description, serve to explain the principles of the invention. In the drawings:

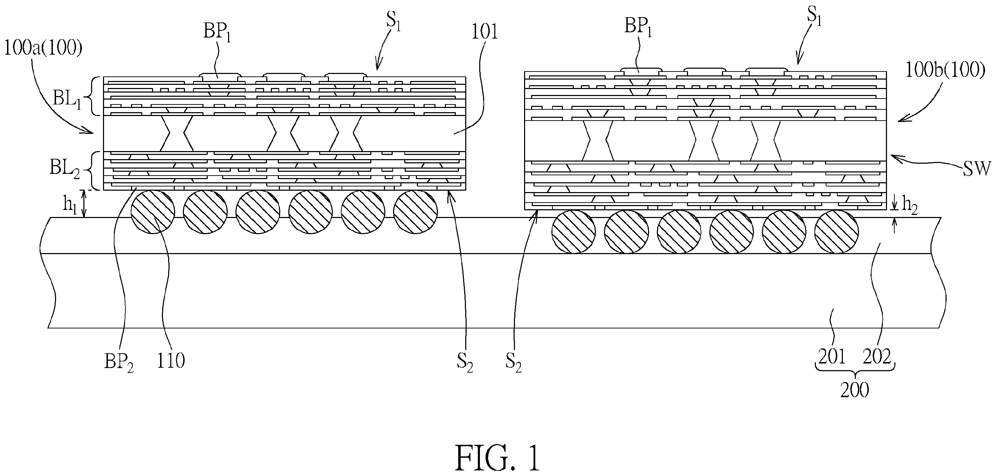

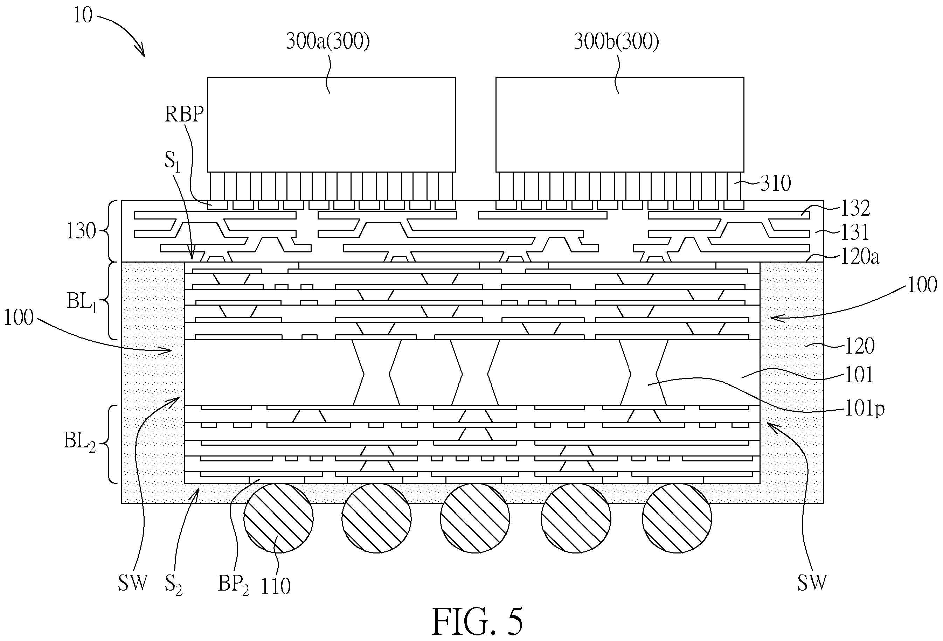

FIG. 1 to FIG. 5 are schematic, cross-sectional diagrams showing an exemplary method for fabricating a semiconductor package with a buried substrate component according to one embodiment that is useful to understand the invention, wherein FIG. 5 shows a cross section of an individual semiconductor package after singulation and de-carrier;

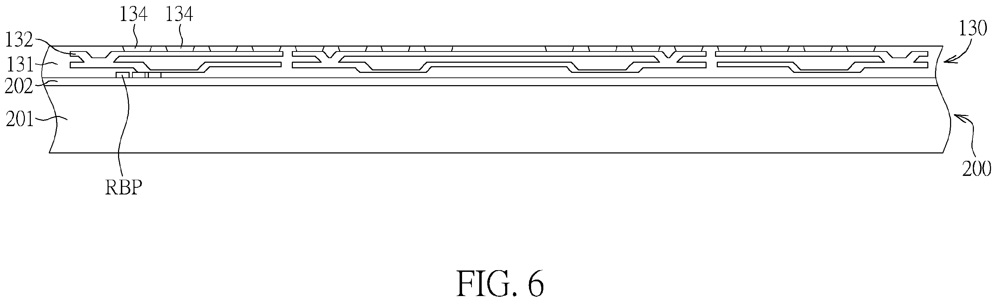

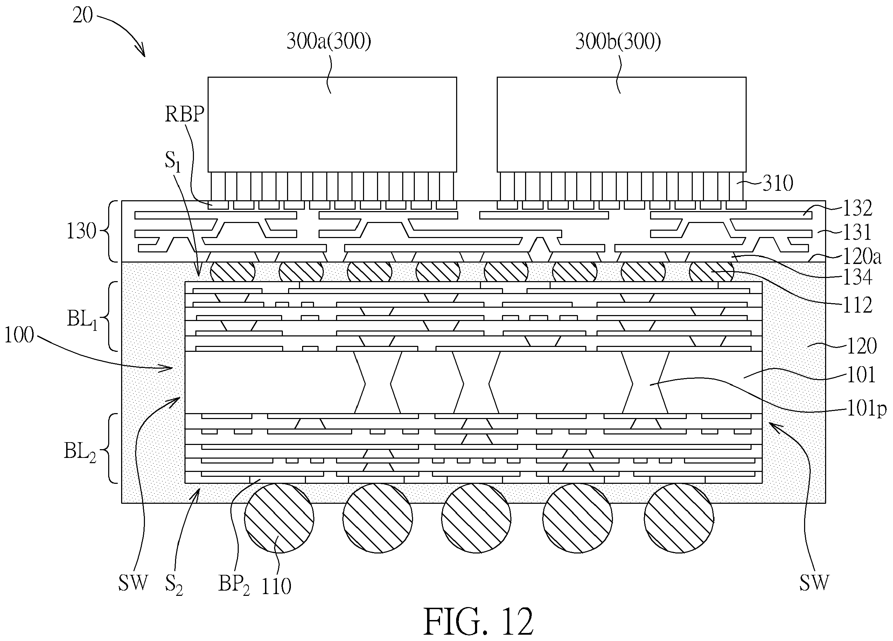

FIG. 6 to FIG. 12 are schematic, cross-sectional diagrams showing an exemplary method for fabricating a semiconductor package with a buried substrate component according to another embodiment that is useful to understand the invention, wherein FIG. 12 shows a cross section of an individual semiconductor package after singulation and de-carrier;

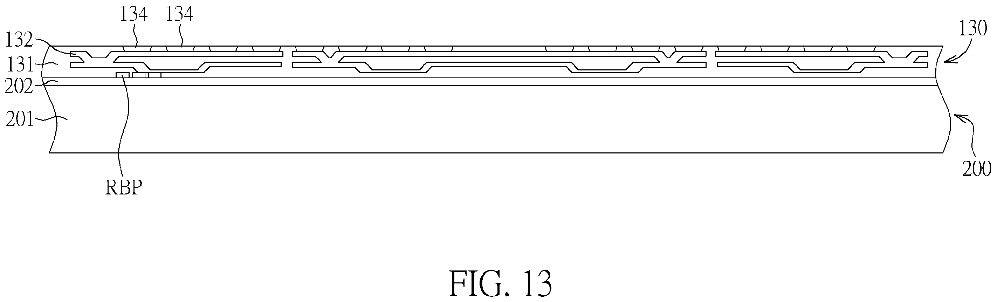

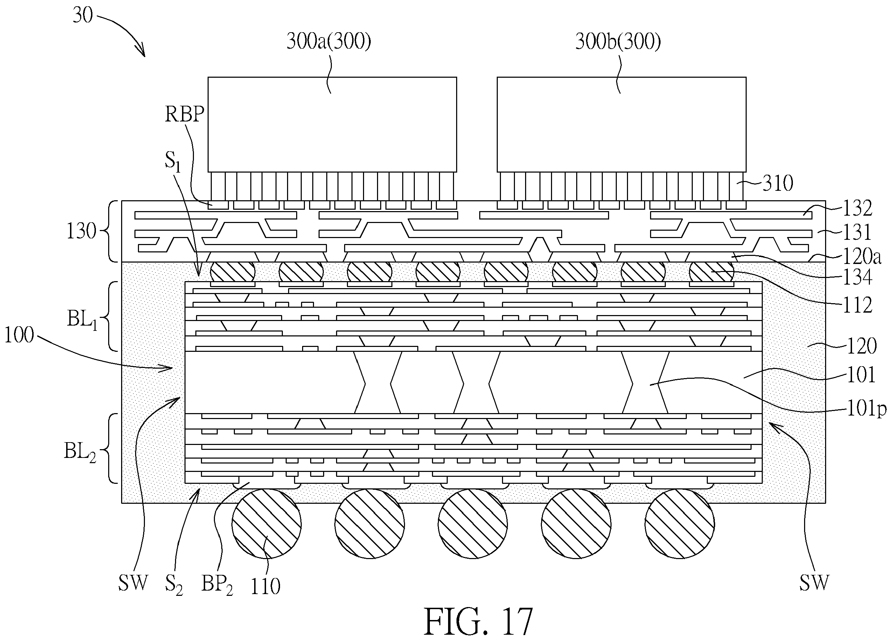

FIG. 13 to FIG. 17 are schematic, cross-sectional diagrams showing an exemplary method for fabricating a semiconductor package with a buried substrate component according to still another embodiment that is useful to understand the invention, wherein FIG. 17 shows a cross section of an individual semiconductor package after functional die placement;

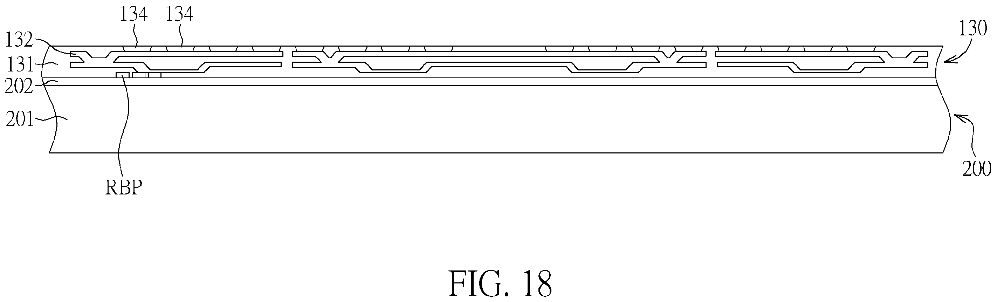

FIG. 18 to FIG. 19 are schematic, cross-sectional diagrams showing an exemplary method for fabricating a semiconductor package with a buried substrate component still according to another embodiment that is useful to understand the invention;

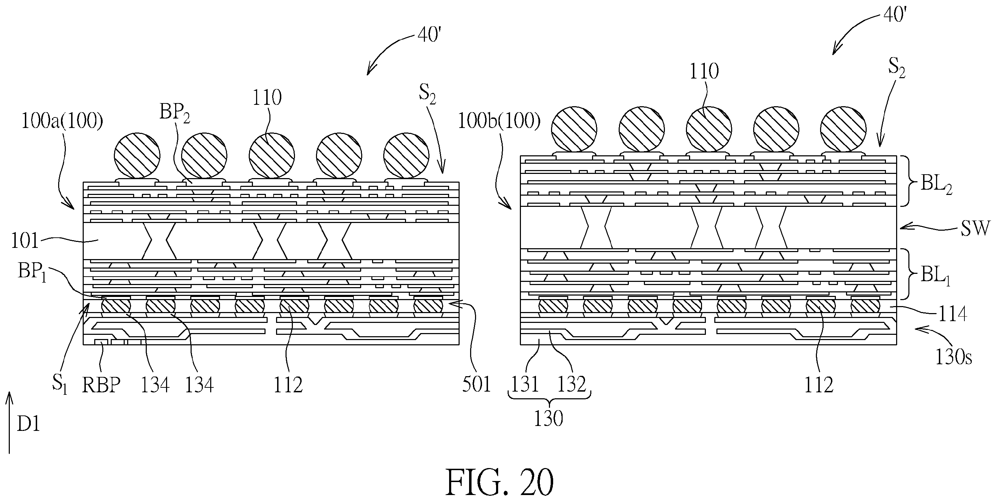

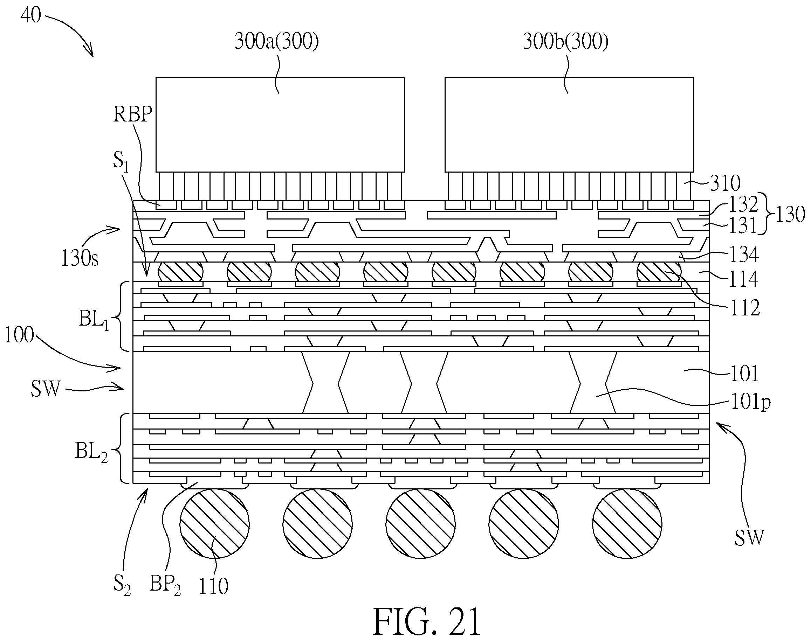

FIG. 20 to FIG. 21 are schematic, cross-sectional diagrams showing an exemplary method for fabricating a semiconductor package with a buried substrate component still according to an embodiment of the invention, wherein a sidewall surface of an RDL structure is aligned with a sidewall surface of a cored substrate component along a vertical direction, and wherein FIG. 21 shows a cross section of an individual semiconductor package after functional die placement; and

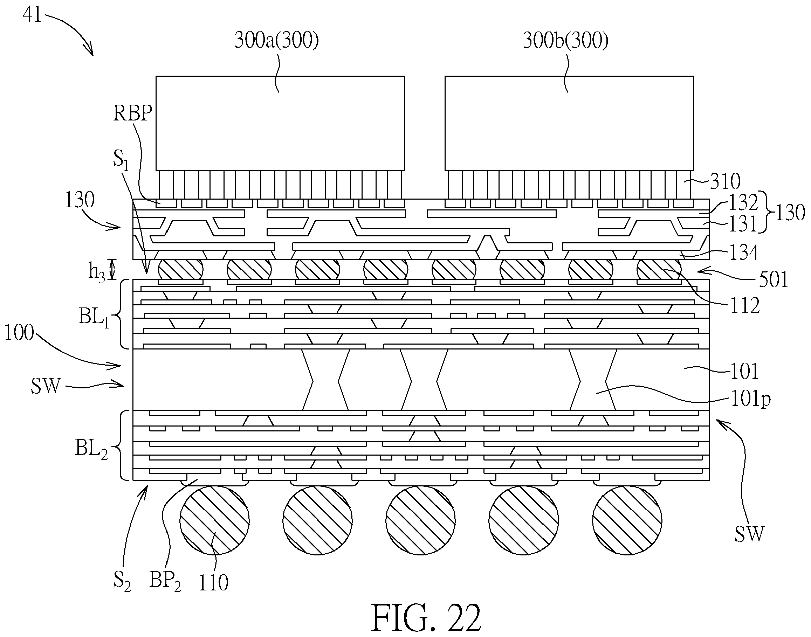

FIG. 22 shows a cross section of a semiconductor package according to another embodiment of the invention.

### Detailed Description

In the following detailed description of embodiments of the invention, reference is made to the accompanying drawings, which form a part hereof, and in which is shown by way of illustration specific preferred embodiments in which the disclosure may be practiced.

These embodiments are described in sufficient detail to enable those skilled in the art to practice them, and it is to be understood that other embodiments may be utilized and that mechanical, chemical, electrical, and procedural changes may be made without departing from the spirit and scope of the present disclosure. The following detailed description is, therefore, not to be taken in a limiting sense, and the scope of embodiments of the present invention is defined only by the appended claims.

It will be understood that when an element or layer is referred to as being "on", "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. Like numbers refer to like elements throughout. As used herein, the term "and/or" includes any and all combinations of one or more of the associated listed items. The abbreviation "BGA" stands for "ball grid array".

Packaging of an integrated circuit (IC) chip can involve attaching the IC chip to a substrate (a packaging substrate) which, among other things, provides mechanical support and electrical connections between the chip and other electronic components of a device. Substrate types include, for example, cored substrates, including thin core, thick core (laminate BT (bismaleimide-triazine resin) or FR-4 type fibrous board material), and laminate core, as well as coreless substrates. Cored package substrates, for example, can be built up layer by layer around a central core, with layers of conductive material (usually copper) separated by layers of insulating dielectric, with interlayer connections being formed with through holes or microvias (vias).

The present disclosure pertains to a chip on RDL on substrate (CRoS) package with fine RDL line/space (e.g., L/S ≤ 2/2 µm; i.e. both of line width and space smaller than or equal to 2µm) integrated on a substrate component. In some embodiments, the substrate component may be a buried, over-molded substrate component. The layer count of the substrate component can be reduced so as to improve the production yield of the substrate component, and the cost of the final package can be reduced. Further, heterogeneous integration with multi-functional devices, passive components or memory can be implemented in one package without preliminary packaging process, e.g., fan-out packaging processes or chip-on-wafer (CoW) processes.

Please refer to FIG. 1 to FIG. 5. FIG. 1 to FIG. 5 are schematic, cross-sectional diagrams showing an exemplary method for fabricating a semiconductor package with a buried substrate component according to one embodiment useful to understand the invention, wherein FIG. 5 shows a cross section of an individual semiconductor package after singulation and de-carrier.

As shown in FIG. 1, a carrier 200 is provided. For example, the carrier 200 may comprise a base substrate 201 such as a glass substrate, a metal substrate, or a plastic substrate in a panel form or a wafer form, but is not limited thereto. Preferably, the carrier 200 may comprise a flexible film 202, such as a resin film or an adhesive film, laminated on an upper surface of the base substrate 201. Preferably, for example, the flexible film 202 may have a thickness of about 200-400µm.

Preferably, a plurality of cored substrate components 100 is distributed on the flexible film 202. Only two cored substrate components 100a and 100b are demonstrated for the sake of simplicity. For example, the cored substrate component 100a may have a thickness that is smaller than that of the cored substrate component 100b due to the process variation. Each of the cored substrates 100 has a first surface S₁ for electrically coupling with at least one chip or electronic device thereon, a second surface S₂ for electrically coupling with an external circuitry such as a printed circuit board or a system board, and a sidewall surface SW extending between the first surface S₁ and the second surface S₂. Each of the cored substrates 100 may comprise a core layer 101, which is composed of a material such as bismaleimide-triazine (BT) resin or the like, and build-up interconnect structure BL₁ and BL₂ disposed on two opposite surfaces of the core layer 101, respectively.

Preferably, a plurality of bonding pads BP₁ is disposed on the first surface S₁ of the cored substrates 100. Preferably, a plurality of solder ball bonding pads BP₂ is disposed on the second surface S₂ of the cored substrates 100 such that solder balls (or BGA balls) 110 can be mounted on the solder ball bonding pads BP₂, respectively, for electrically connecting an external electronic device such as a printed circuit board (not shown). Preferably, at least part of each of the solder balls 110 sinks and is buried into the flexible film 202.

By controlling the proportion of the solder balls 110 embedded in the flexible film 202, the first surfaces S₁ of the two exemplary cored substrate components 100a and 100b can be coplanar. Preferably, a standoff height h₁ between the cored substrate component 100a and a top surface of the flexible film 202 is greater than a standoff height h₂ between the cored substrate component 100b and the top surface of the flexible film 202.

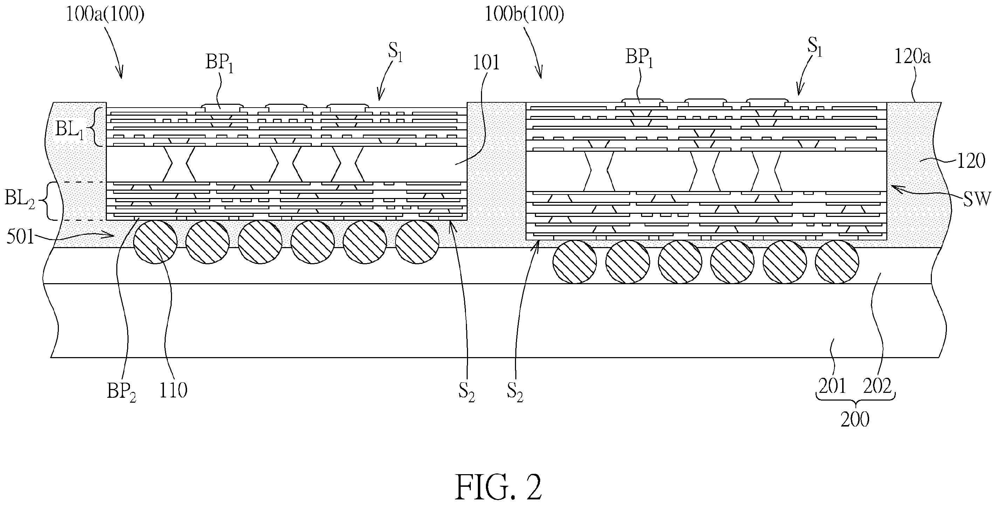

As shown in FIG. 2, subsequently, the plurality of cored substrate components 100 is over-molded by an encapsulant 120 by performing a molding process. For example, the molding process may be compression molding. Preferably, the molding process may be performed by dispensing, but is not limited thereto. Preferably, the encapsulant 120 may comprise an engineered molding compound comprising an epoxy or a resin, but is not limited thereto. Preferably, the encapsulant 120 may surround each of the cored substrate components 100 and may fill into the gap 501 between each of the cored substrate components 100 and the carrier 200. Therefore, the encapsulant 120 may cover the second surface S₂ and the sidewall surface SW.

After the molding process is completed, a polishing process or a grinding process is performed to remove excess encapsulant 120 from the first surface S₁ of each of the plurality of cored substrate components 100, thereby revealing the plurality of flip-chip bonding pads BP₁. At this point, the first surface S₁ of each of the plurality of cored substrate components 100 is approximately flush with an upper surface 120a of the encapsulant 120.

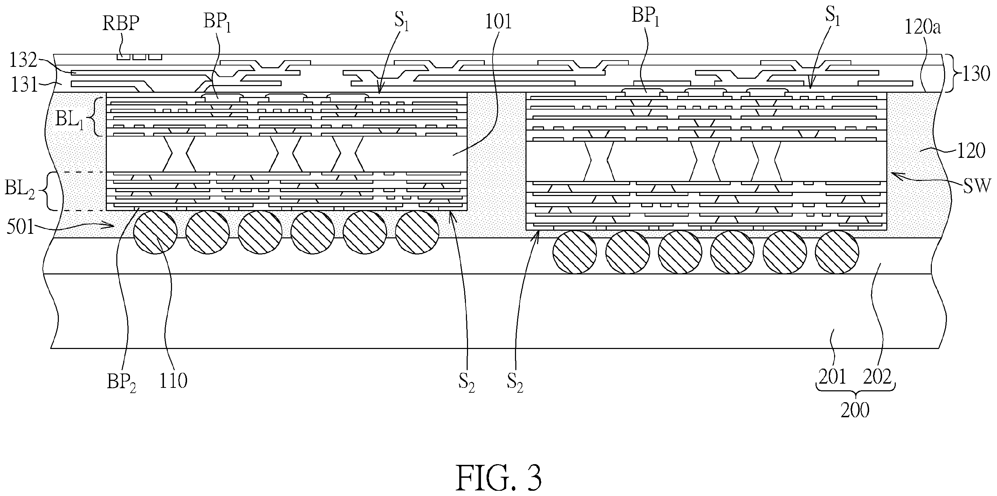

As shown in FIG. 3, a re-distribution layer (RDL) structure 130 is then formed directly on the exposed first surface S₁ of each of the plurality of cored substrate components 100 and on the upper surface 120a of the encapsulant 120. A portion of the RDL structure 130 protrudes beyond the sidewall surface SW of the cored substrate component 100. Preferably, the formation of the RDL structure 130 may generally involve the steps of dielectric deposition, metal (e.g., copper) plating, lithography, etching, and/or chemical mechanical polishing (CMP), etc. The RDL structure 130 may comprise dielectric layers 131, traces 132 in the dielectric layers 131, and re-distributed bonding pads RBP for connecting with an integrated circuit chip or die.

The dielectric layers 131 may comprise silicon oxide, silicon oxy-nitride, silicon nitride, and/or low-k dielectric layers, but is not limited thereto. It is noteworthy that no copper post or copper pillar is formed between the RDL structure 130 and the plurality of cored substrate components 100. Therefore, the cost of the package can be reduced and the performance of the package can be improved.

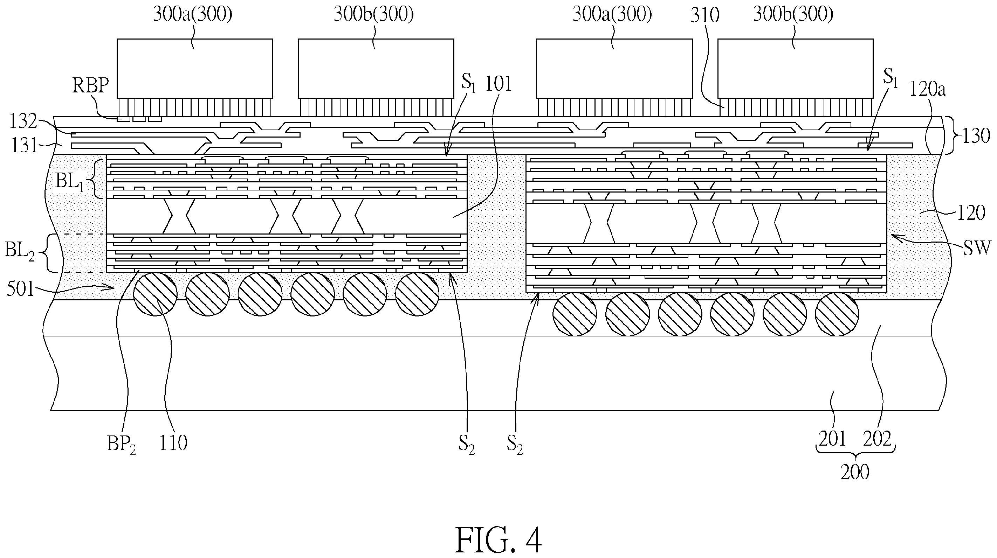

After the RDL structure 130 is completed, at least one integrated circuit die is mounted on the RDL structure 130. As shown in FIG. 4, for example, functional chips or dies 300 may be mounted on the RDL structure 130 through the connecting elements 310 such as metal bumps, solder bumps, solder-capped metal bumps, micro-bumps, C4 bumps, metal pillars, or the like. The functional dies 300 may comprise a first die 300a and a second die 300b, for example, for each package. The first die 300a may have a function different from that of the second die 300b so as to achieve heterogeneous integration. For example, the first die 300a may be a system on a chip (SoC) and the second die 300b may be a memory die, but is not limited thereto. It is to be understood that various functional dies such as passive components, antenna components, or the like may also be employed.

Preferably, prior to the placement of the functional chips or dies 300, a circuit test for the RDL structure 130 may be performed. If the RDL structure 130 of a particular package fails the test, dummy dies may be mounted on the RDL structure that fails the test, instead of the functional dies.

Subsequently, a de-carrier process may be performed to detach the carrier 200 and a dicing process or a cutting process may be performed to singulate the individual semiconductor package, as shown in FIG. 5.

Preferably, as shown in FIG. 5, the semiconductor package 10 may be a multi-die package and comprises the cored substrate component 100 having a core layer 101, which is composed of a material such as bismaleimide-triazine resin or the like, and build-up interconnect structure BL₁ and BL₂ disposed on two opposite surfaces of the core layer 101, respectively. A plurality of plated through holes (PTHs) 101p may be provided in the core layer 101 for electrically connecting the build-up interconnect structure BL₁ with the build-up interconnect structure BL₂. For example, preferably, the cored substrate component 100 may be a 2-layer, 4-layer, or 6-layer substrate, but is not limited thereto.

The cored substrate component 100 is surrounded by the encapsulant 120. The cored substrate component 100 has the first surface S₁ for mounting at least one chip or electronic device thereon, the second surface S₂ for electrically coupling with an external circuitry such as a printed circuit board or a system board, and a sidewall surface SW extending between the first surface S₁ and the second surface S₂. The solder balls 110 are mounted on the solder ball bonding pads BP₂, respectively, on the second surface S₂. Preferably, the sidewall surface SW is covered by the encapsulant 120. Preferably, the second surface S₂ is at least partially covered by the encapsulant 120. Preferably, the encapsulant 120 is in direct contact with an upper portion of each of the solder balls 110.

The first surface S₁ of the cored substrate component 100 is flush with the upper surface 120a of the encapsulant 120. The RDL structure 130 is formed on the first surface S₁ of the cored substrate component 100 and on the upper surface 120a of the encapsulant 120. Preferably, the RDL structure 130 comprises dielectric layers 131, traces 132 in the dielectric layers 131, and re-distributed bonding pads RBP for connecting with an integrated circuit chip or die. The dielectric layers 131 may comprise silicon oxide, silicon oxy-nitride, silicon nitride, and/or low-k dielectric layers, but is not limited thereto. Preferably, the RDL structure 130 can have a tighter RDL pitch (i.e., L/S ≤ 2/2 µm).

It is noteworthy that no copper post or copper pillar is formed between the RDL structure 130 and the cored substrate component 100 since the RDL structure 130 is fabricated directly on the first surface S₁ of the substrate component 100 and on the upper surface 120a of the encapsulant 120. Therefore, the cost of the package can be reduced and the performance of the package can be improved.

Preferably, the semiconductor package 10 further comprises the first die 300a and the second die 300b mounted on the RDL structure 130 through the connecting elements 310. The connecting elements 310 may comprise metal bumps, solder bumps, solder-capped metal bumps, micro-bumps, C4 bumps, metal pillars, or the like. Preferably, the first die 300a may have a function different from that of the second die 300b so as to achieve heterogeneous integration. For example, the first die 300a may be a system on a chip (SoC) and the second die 300b may be a memory die, but is not limited thereto. It is to be understood that various functional dies such as passive components, antenna components, or the like may also be employed.

Please refer to FIG. 6 to FIG. 12. FIG. 6 to FIG. 12 are schematic, cross-sectional diagrams showing an exemplary "RDL-first" method for fabricating a semiconductor package with a buried substrate component according to another embodiment useful to understand the invention, wherein like layers, regions, or elements are designated by like numeral numbers or labels. FIG. 12 shows a cross section of an individual semiconductor package after singulation and de-carrier.

As shown in FIG. 6, likewise, a carrier 200 is provided. For example, the carrier 200 may comprise a base substrate 201 such as a glass substrate, a metal substrate, or a plastic substrate in a panel form or a wafer form, but is not limited thereto. Preferably, the carrier 200 may comprise a flexible film 202, such as a resin film, a release film, or an adhesive film, laminated on an upper surface of the base substrate 201.

An RDL structure 130 is then formed on the flexible film 202. Preferably, the formation of the RDL structure 130 may generally involve the steps of dielectric deposition, metal (e.g., copper) plating, lithography, etching, and/or CMP, etc. The RDL structure 130 may comprise dielectric layers 131, traces 132 in the dielectric layers 131, bonding pads 134 at an upper surface of the RDL structure 130 for connecting with a substrate component, and re-distributed bonding pads RBP at a lower surface of the RDL structure 130 for connecting with an integrated circuit chip or die. Preferably, the dielectric layers 131 may comprise silicon oxide, silicon oxy-nitride, silicon nitride, and/or low-k dielectric layers, but is not limited thereto.

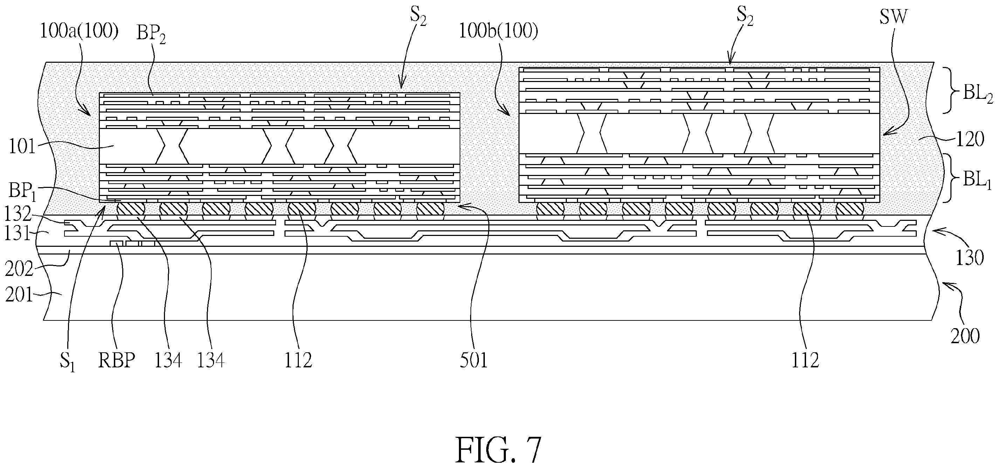

As shown in FIG. 7, a plurality of cored substrate components (or substrate components) 100 is distributed on the RDL structure 130. For the sake of simplicity, only two cored substrate components 100a and 100b are demonstrated. For example, the cored substrate component 100a may have a thickness that is smaller than that of the cored substrate component 100b due to the process variation. Each of the cored substrates 100 has a first surface S₁ for electrically coupling with at least one chip or electronic device thereon, a second surface S₂ for electrically coupling with an external circuitry such as a printed circuit board or a system board, and a sidewall surface SW extending between the first surface S₁ and the second surface S₂. Each of the cored substrates 100 may comprise a core layer 101, which is composed of a material such as bismaleimide-triazine (BT) resin or the like, and build-up interconnect structure BL₁ and BL₂ disposed on two opposite surfaces of the core layer 101, respectively.

Preferably, the cored substrate component 100a and the cored substrate component 100b are mounted to the RDL structure 130 through a plurality of connecting elements 112 such as solder bumps or solder balls. Preferably, the second surface S₂ of the cored substrate component 100a may be not leveled with the second surface S₂ of the cored substrate component 100b. Preferably, a plurality of bonding pads BP₁ is disposed on the first surface S₁ of the cored substrates 100. Preferably, a plurality of solder ball bonding pads BP₂ is disposed on the second surface S₂ of the cored substrates 100.

Subsequently, the cored substrate components 100a and 100b are over-molded by an encapsulant 120 by performing a molding process. For example, the molding process may be compression molding. Preferably, the molding process may be performed by dispensing, but is not limited thereto. Preferably, the encapsulant 120 may comprise a molding compound comprising an epoxy or a resin, but is not limited thereto. Preferably, the encapsulant 120 may surround each of the cored substrate components 100 and may fill into the gap between each of the cored substrate components 100 and the carrier 200. Preferably, the second surface S₂ that faces upwardly at this point is also covered with the encapsulant 120.

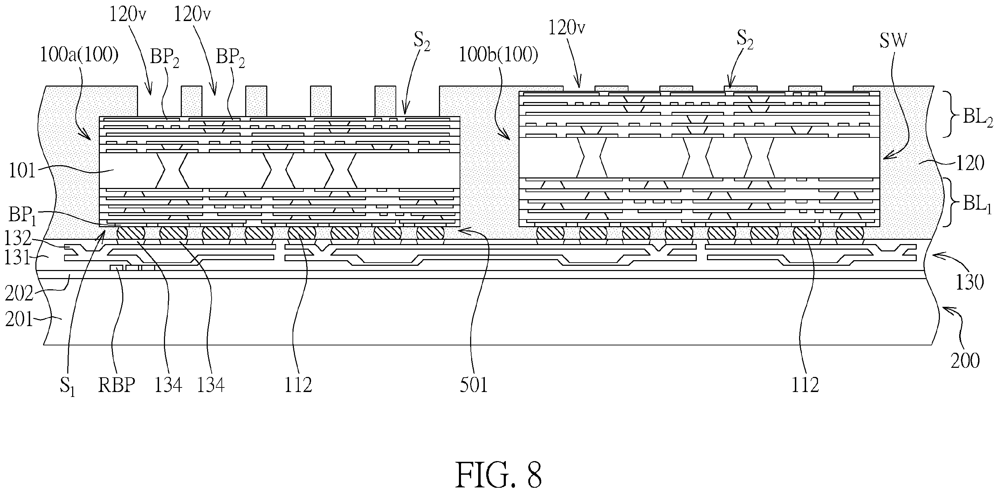

As shown in FIG.8, via holes 120v are formed in the encapsulant 120 to expose the solder ball bonding pads BP₂ on the second surface S₂ of the cored substrates 100, respectively. Preferably, the via holes 120v may be formed by laser drilling processes, but is not limited thereto.

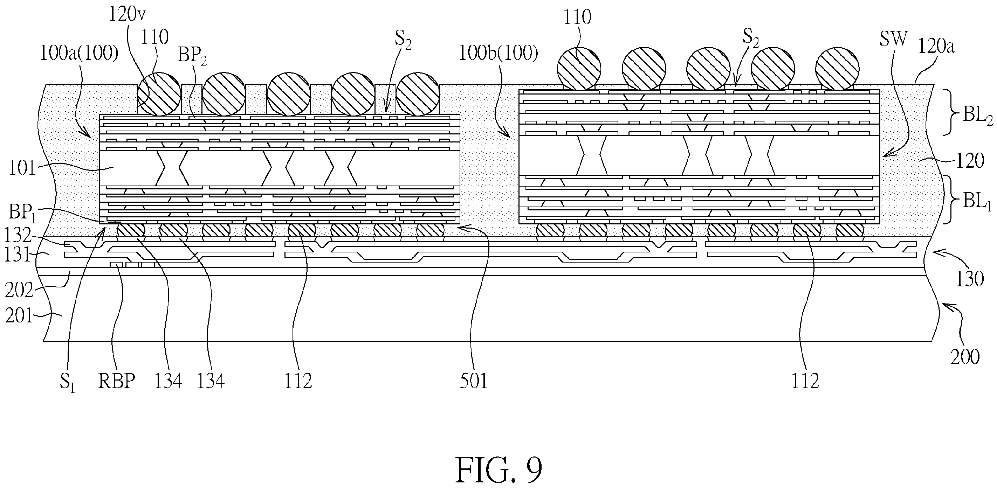

As shown in FIG. 9, subsequently, a plurality of solder balls 110 can be disposed on the solder ball bonding pads BP₂ within the via holes 120v, respectively, for electrically connecting an external electronic device such as a printed circuit board (not shown).

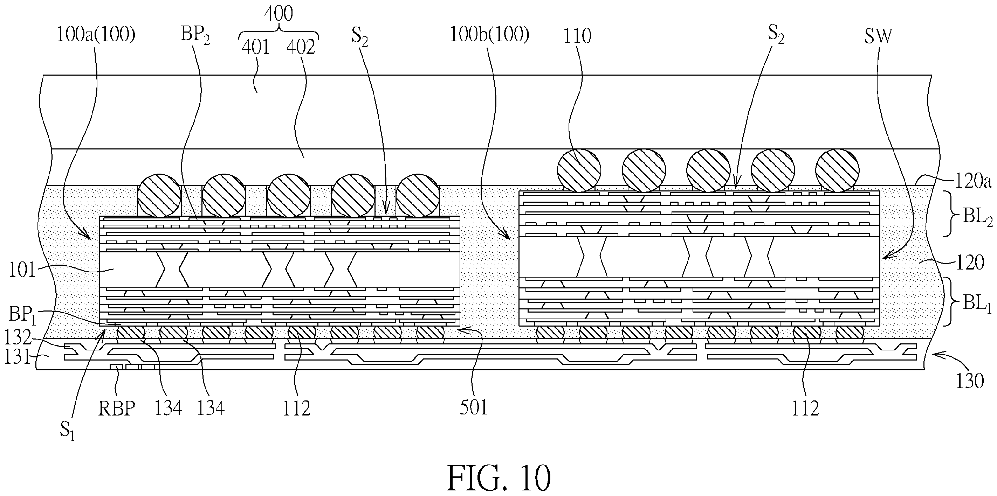

As shown in FIG. 10, another carrier 400 is attached to the upper surface 120a of the encapsulant 120. Preferably, the carrier 400 may comprise a base substrate 401 such as a glass substrate, a metal substrate, or a plastic substrate in a panel form or a wafer form, but is not limited thereto. Preferably, the carrier 400 may comprise a flexible film 402, such as a resin film or an adhesive film, laminated on an upper surface of the base substrate 401.

Preferably, the solder balls 110 may be at least partially buried in the flexible film 402. Subsequently, a de-bonding process may be performed to remove the carrier 200 from a lower surface of the RDL structure 130. At this point, the re-distributed bonding pads RBP for connecting with an integrated circuit chip or die are revealed.

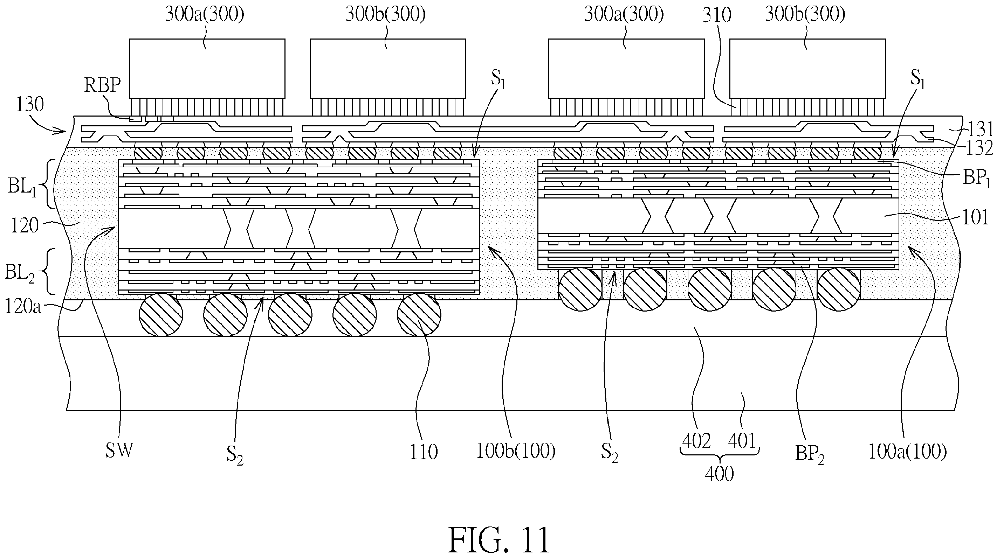

As shown in FIG. 11, the carrier 400 with the components mounted thereon is flipped 180 degrees. Subsequently, functional chips or dies 300 are mounted on the RDL structure 130 through the connecting elements 310 such as metal bumps, solder bumps, solder-capped metal bumps, micro-bumps, C4 bumps, metal pillars, or the like. The functional dies 300 may comprise a first die 300a and a second die 300b, for example, for each package. The first die 300a may have a function different from that of the second die 300b so as to achieve heterogeneous integration. For example, the first die 300a may be a system on a chip (SoC) and the second die 300b may be a memory die, but is not limited thereto. It is to be understood that various functional dies such as passive components, antenna components, or the like may also be employed.

Preferably, prior to the placement of the functional chips or dies 300, a circuit test for the RDL structure 130 may be performed. If the RDL structure 130 of a particular package fails the test, dummy dies may be mounted on the RDL structure that fails the test, instead of the functional dies.

Subsequently, a de-carrier process may be performed to detach the carrier 400 and a dicing process or a cutting process may be performed to singulate the individual semiconductor package, as shown in FIG. 12.

Preferably, as shown in FIG. 12, the semiconductor package 20 may be a multi-die package and comprises the cored substrate component 100 having a core layer 101, which is composed of a material such as bismaleimide-triazine resin or the like, and build-up interconnect structure BL₁ and BL₂ disposed on two opposite surfaces of the core layer 101, respectively. Likewise, a plurality of plated through holes (PTHs) 101p may be provided in the core layer 101. For example, preferably, the cored substrate component 100 may be a 2-layer, 4-layer, or 6-layer substrate.

The cored substrate component 100 is surrounded by the encapsulant 120. The cored substrate component 100 has the first surface S₁ for mounting at least one chip or electronic device thereon, the second surface S₂ for electrically coupling with an external circuitry such as a printed circuit board or a system board, and a sidewall surface SW extending between the first surface S₁ and the second surface S₂. The solder balls 110 are mounted on the solder ball bonding pads BP₂, respectively, on the second surface S₂. Preferably, the sidewall surface SW is covered by the encapsulant 120. Preferably, the second surface S₂ is at least partially covered by the encapsulant 120. Preferably, the encapsulant 120 is in direct contact with an upper portion of each of the solder balls 110.

Preferably, the first surface S₁ is at least partially covered by the encapsulant 120. Therefore, the first surface S₁ of the cored substrate component 100 is not flush with the upper surface 120a of the encapsulant 120. The connecting elements 112 are disposed on the bonding pads BP₁ for further connection, respectively. The connecting elements 112 are surrounded by the encapsulant 120.

The RDL structure 130 is formed on the upper surface 120a of the encapsulant 120. Preferably, the RDL structure 130 comprises dielectric layers 131, traces 132 in the dielectric layers 131, and re-distributed bonding pads RBP for connecting with an integrated circuit chip or die. The dielectric layers 131 may comprise silicon oxide, silicon oxy-nitride, silicon nitride, and/or low-k dielectric layers, but is not limited thereto. Preferably, the RDL structure 130 can have a tighter RDL pitch (i.e., L/S ≤ 2/2 µm).

It is noteworthy that no copper post or copper pillar is formed between the RDL structure 130 and the cored substrate component 100. Therefore, the cost of the package can be reduced and the performance of the package can be improved. Further, since the RDL structure 130 is formed first on the carrier 200, the production yield of the package can be improved.

Preferably, the semiconductor package 10 further comprises the first die 300a and the second die 300b mounted on the RDL structure 130 through the connecting elements 310. The connecting elements 310 may comprise metal bumps, solder bumps, solder-capped metal bumps, micro-bumps, C4 bumps, metal pillars, or the like. Preferably, the first die 300a may have a function different from that of the second die 300b so as to achieve heterogeneous integration. For example, the first die 300a may be a SoC and the second die 300b may be a memory die, but is not limited thereto. It is to be understood that various functional dies such as passive components, antenna components, or the like may also be employed.

Please refer to FIG. 13 to FIG. 17. FIG. 13 to FIG. 17 are schematic, cross-sectional diagrams showing an exemplary "RDL-first" method for fabricating a semiconductor package with a buried substrate component according to another embodiment useful to understand the invention, wherein like layers, regions, or elements are designated by like numeral numbers or labels. FIG. 17 shows a cross section of an individual semiconductor package after functional die placement.

As shown in FIG. 13, likewise, a carrier 200 is provided. For example, the carrier 200 may comprise a base substrate 201 such as a glass substrate, a metal substrate, or a plastic substrate in a panel form or a wafer form, but is not limited thereto. Preferably, the carrier 200 may comprise a flexible film 202, such as a resin film, a release film, or an adhesive film, laminated on an upper surface of the base substrate 201.

An RDL structure 130 is then formed on the flexible film 202. Preferably, the formation of the RDL structure 130 may generally involve the steps of dielectric deposition, metal (e.g., copper) plating, lithography, etching, and/or CMP, etc. The RDL structure 130 may comprise dielectric layers 131, traces 132 in the dielectric layers 131, bonding pads 134 at an upper surface of the RDL structure 130 for connecting with a substrate component, and re-distributed bonding pads RBP at a lower surface of the RDL structure 130 for connecting with an integrated circuit chip or die. Preferably, the dielectric layers 131 may comprise silicon oxide, silicon oxy-nitride, silicon nitride, and/or low-k dielectric layers, but is not limited thereto. Preferably, the RDL structure 130 can have a tighter RDL pitch (i.e., L/S ≤ 2/2 µm).

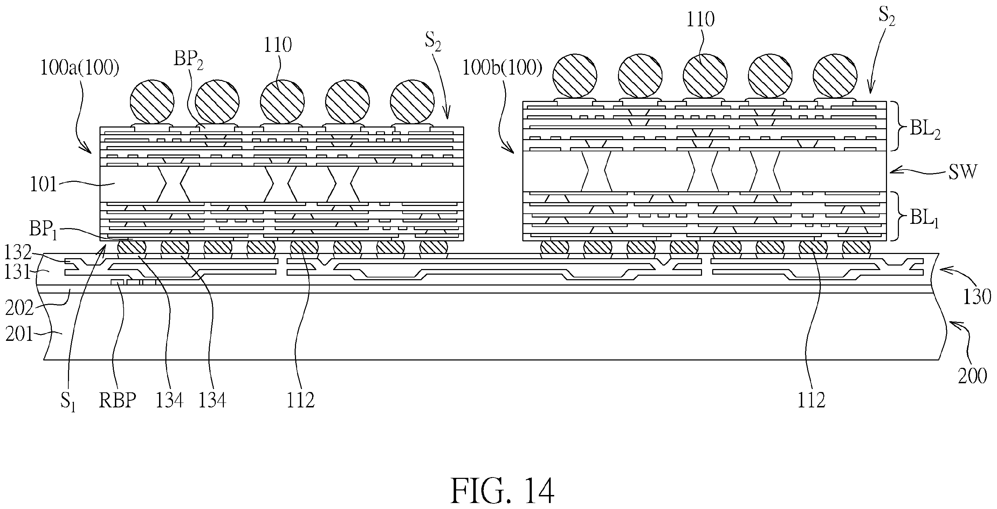

As shown in FIG. 14, a plurality of cored substrate components (or BGA substrate components) 100 is distributed on the RDL structure 130. For the sake of simplicity, only two cored substrate components 100a and 100b are demonstrated. For example, the cored substrate component 100a may have a thickness that is smaller than that of the cored substrate component 100b due to the process variation. Each of the cored substrates 100 has a first surface S₁ for electrically coupling with at least one chip or electronic device thereon and a second surface S₂ for electrically coupling with an external circuitry such as a printed circuit board or a system board. Each of the cored substrates 100 may comprise a core layer 101, which is composed of a material such as bismaleimide-triazine resin or the like, and build-up interconnect structure BL₁ and BL₂ disposed on two opposite surfaces of the core layer 101, respectively.

Preferably, the cored substrate component 100a and the cored substrate component 100b are mounted to the RDL structure 130 through a plurality of connecting elements 112 such as solder bumps or solder balls. Preferably, the second surface S₂ of the cored substrate component 100a may be not leveled with the second surface S₂ of the cored substrate component 100b. Preferably, a plurality of bonding pads BP₁ is disposed on the first surface S₁ of the cored substrates 100. Preferably, a plurality of solder ball bonding pads BP₂ is disposed on the second surface S₂ of the cored substrates 100. Solder balls (or BGA balls) 110 are provided on the solder ball bonding pads BP₂, respectively.

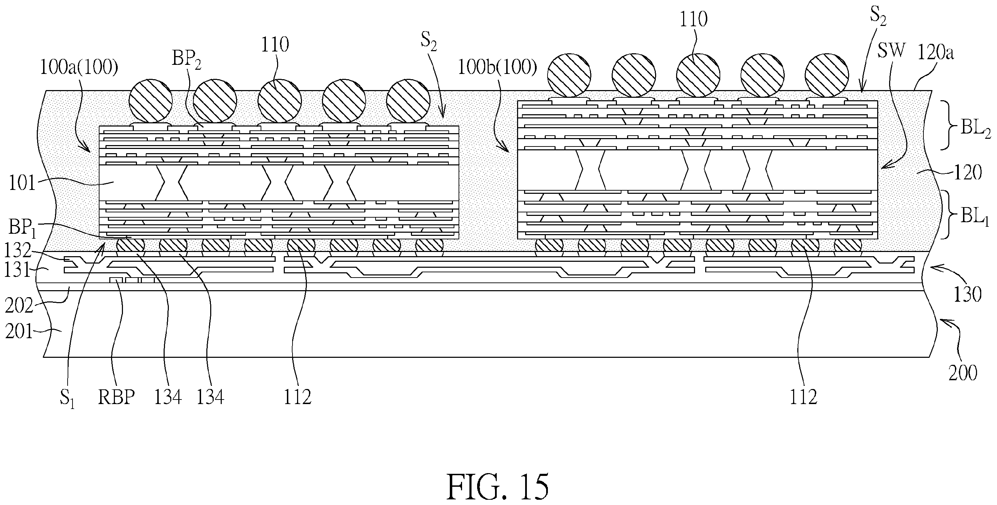

As shown in FIG. 15, subsequently, the cored substrate components 100a and 100b are over-molded by an encapsulant 120 by performing a molding process. For example, the molding process may be compression molding. Preferably, the molding process may be performed by dispensing, but is not limited thereto. Preferably, the encapsulant 120 may comprise a molding compound comprising an epoxy or a resin, but is not limited thereto. Preferably, the encapsulant 120 may surround each of the cored substrate components 100 and may fill into the gap between each of the cored substrate components 100 and the carrier 200. Preferably, the second surface S₂ that faces upwardly at this point is also covered with the encapsulant 120 and each of the solder balls 110 is at least partially revealed.

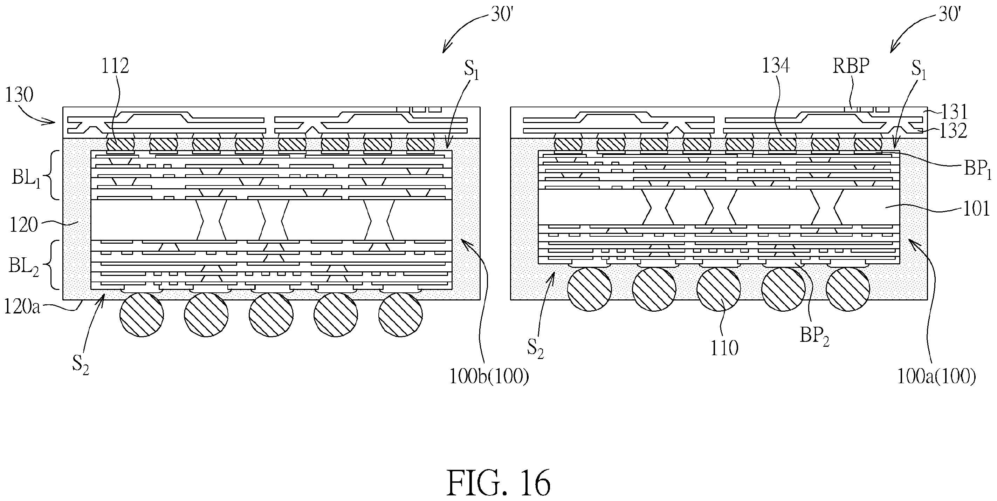

As shown in FIG. 16, a de-carrier process may be performed to detach the carrier 200 and a dicing process or a cutting process may be performed to singulate the individual package 30'.

As shown in FIG. 17, subsequently, functional chips or dies 300 are mounted on the RDL structure 130 through the connecting elements 310 such as metal bumps, solder bumps, solder-capped metal bumps, micro-bumps, C4 bumps, metal pillars, or the like, thereby forming the semiconductor package 30. The functional dies 300 may comprise a first die 300a and a second die 300b, for example, for each package. The first die 300a may have a function different from that of the second die 300b so as to achieve heterogeneous integration. For example, the first die 300a may be a SoC and the second die 300b may be a memory die, but is not limited thereto. It is to be understood that various functional dies such as passive components, antenna components, or the like may also be employed.

Preferably, prior to the placement of the functional chips or dies 300, a circuit test for the RDL structure 130 may be performed. If the RDL structure 130 of a particular package fails the test, dummy dies may be mounted on the RDL structure that fails the test, instead of the functional dies.

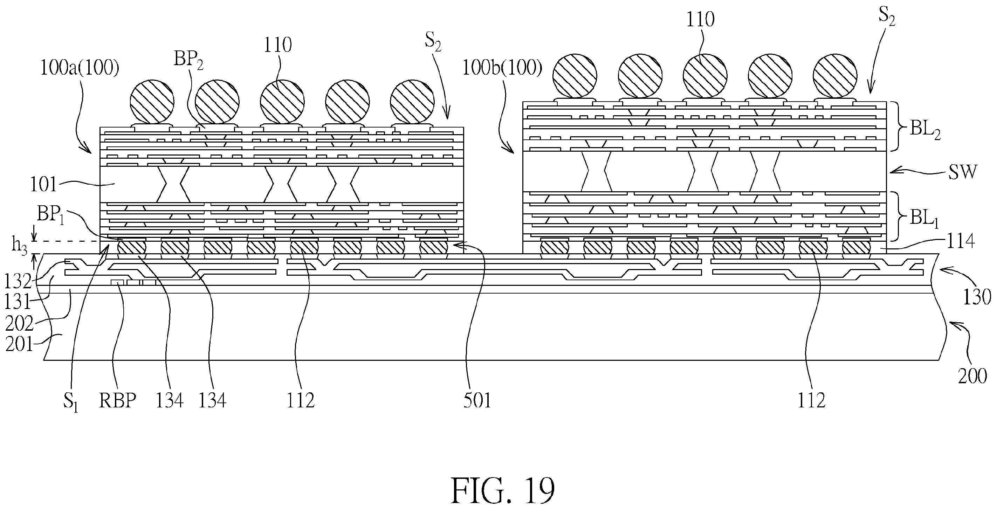

Please refer to FIG. 18 to FIG. 21. FIG. 18 and FIG. 19 are schematic, cross-sectional diagrams showing an exemplary "RDL-first" method for fabricating a semiconductor package with a buried substrate component according to another embodiment useful to understand the invention. FIG. 20 and FIG. 21 are schematic, cross-sectional diagrams showing an exemplary "RDL-first" method for fabricating a semiconductor package with a buried substrate component according to an embodiment of the invention, wherein a sidewall surface of an RDL structure is aligned with a sidewall surface of a cored substrate component along a vertical direction. In FIG. 18 to FIG 21, like layers, regions, or elements are designated by like numeral numbers or labels. FIG. 21 shows a cross section of an individual semiconductor package after functional die placement.

As shown in FIG. 18, likewise, a carrier 200 is provided. For example, the carrier 200 may comprise a base substrate 201 such as a glass substrate, a metal substrate, or a plastic substrate in a panel form or a wafer form, but is not limited thereto. Preferably, the carrier 200 may comprise a flexible film 202, such as a resin film, a release film, or an adhesive film, laminated on an upper surface of the base substrate 201.

An RDL structure 130 is then formed on the flexible film 202. Preferably, the formation of the RDL structure 130 may generally involve the steps of dielectric deposition, metal (e.g., copper) plating, lithography, etching, and/or CMP, etc. The RDL structure 130 may comprise dielectric layers 131, traces 132 in the dielectric layers 131, bonding pads 134 at an upper surface (or a substrate-side surface) of the RDL structure 130 for connecting with a substrate component, and re-distributed bonding pads RBP at a lower surface (or a chip-side surface) of the RDL structure 130 for connecting with an integrated circuit chip or die. Preferably, the dielectric layers 131 may comprise silicon oxide, silicon oxy-nitride, silicon nitride, and/or low-k dielectric layers, but is not limited thereto. Preferably, the RDL structure 130 can have a tighter RDL pitch (i.e., L/S ≤ 2/2 µm).

As shown in FIG. 19, a plurality of cored substrate components (or BGA substrate components) 100 is distributed on the RDL structure 130. For the sake of simplicity, only two cored substrate components 100a and 100b are demonstrated. For example, the cored substrate component 100a may have a thickness that is smaller than that of the cored substrate component 100b due to the process variation. Each of the cored substrates 100 has a first surface S₁ for electrically coupling with at least one chip or electronic device thereon and a second surface S₂ for electrically coupling with an external circuitry such as a printed circuit board or a system board. Each of the cored substrates 100 may comprise a core layer 101, which is composed of a material such as bismaleimide-triazine resin or the like, and build-up interconnect structure BL₁ and BL₂ disposed on two opposite surfaces of the core layer 101, respectively.

Preferably, the cored substrate component 100a and the cored substrate component 100b are mounted to the RDL structure 130 through a plurality of connecting elements 112 such as solder bumps or solder balls. Preferably, the second surface S₂ of the cored substrate component 100a may be not leveled with the second surface S₂ of the cored substrate component 100b. Preferably, a plurality of bonding pads BP₁ is disposed on the first surface S₁ of the cored substrates 100. Preferably, a plurality of solder ball bonding pads BP₂ is disposed on the second surface S₂ of the cored substrates 100. Solder balls (or BGA balls) 110 are provided on the solder ball bonding pads BP₂, respectively.

Preferably, a gap 501 is disposed between the RDL structure 130 and the cored substrate component 100. Preferably, optionally, the gap 501 between the first surface S₁ and the RDL structure 130 may be filled with an underfill 114 and the connecting elements 112 are surrounded by the underfill 114. The gap 501 may have a standoff height h₃ that is smaller than 100 µm. Preferably, the standoff height h₃ may be smaller than 80 µm. Preferably, the underfill 114 may comprise a non-conductive paste or a non-conductive film, but is not limited thereto.

As shown in FIG. 20, a de-carrier process may be performed to detach the carrier 200 and a dicing process or a cutting process may be performed to singulate the individual package 40'. A sidewall surface 130s of the RDL structure is aligned with the sidewall surface SW of the cored substrate component 100 along a vertical direction D₁.

As shown in FIG. 21, subsequently, at least one integrated circuit chip or die such as functional chips or dies 300 are mounted on the RDL structure 130 through the connecting elements 310 such as metal bumps, solder bumps, solder-capped metal bumps, micro-bumps, C4 bumps, metal pillars, or the like, thereby forming the semiconductor package 40. The functional dies 300 may comprise a first die 300a and a second die 300b, for example, for each package. The first die 300a may have a function different from that of the second die 300b so as to achieve heterogeneous integration. For example, the first die 300a may be a SoC and the second die 300b may be a memory die, but is not limited thereto. It is to be understood that various functional dies such as passive components, antenna components, or the like may also be employed.

Preferably, prior to the placement of the functional chips or dies 300, a circuit test for the RDL structure 130 may be performed. If the RDL structure 130 of a particular package fails the test, dummy dies may be mounted on the RDL structure that fails the test, instead of the functional dies.

In this embodiment, a molding process is omitted. That is, the first surface S₁, the second surface S₂, and the sidewall surface SW of the cored substrate component 100 are not covered with an encapsulant. Therefore, the warpage problem of the semiconductor package 40 can be improved.

FIG. 22 is a cross-sectional diagram showing a semiconductor package without underfill according to another embodiment of the invention, wherein like layers, regions, or elements are designated by like numeral numbers or labels. As shown in FIG. 22, the semiconductor package 41 is similar to the semiconductor package 40 as shown in FIG. 21. The difference between the semiconductor package 41 and the semiconductor package 40 is that the semiconductor package 41 does not include an underfill between the RDL structure 130 and the cored substrate component 100. That is, a gap 501 between the RDL structure 130 and the cored substrate component 100 is not filled with an underfill and the connecting elements 112 are at least partially exposed. The gap 501 has a standoff height h₃ that is smaller than 100 µm. Preferably, the standoff height h₃ is smaller than 80 µm.

Those skilled in the art will readily observe that numerous modifications and alterations of the device and method may be made while retaining the teachings of the invention. Accordingly, the above disclosure should be construed as limited only by the metes and bounds of the appended claims.

## Claims

1. A semiconductor package (40; 41), comprising:
a substrate component (100) comprising a first surface (S₁), a second surface (S₂) opposite to said first surface (S₁), and a sidewall surface (SW) extending between said first surface (S₁) and said second surface (S₂);
a re-distribution layer, in the following also referred to as RDL, structure (130) disposed on said first surface (S₁) and electrically connected to said first surface (S₁) through first connecting elements (112) comprising solder bumps or balls;
a plurality of ball grid array, in the following also referred to as BGA, balls (110) mounted on said second surface (S₂) of said substrate component (100); and
at least one integrated circuit die (300) mounted on said RDL structure (130) through second connecting elements (310);
**characterized in that**
a sidewall surface of said RDL structure (130) is aligned with said sidewall surface (SW) of said substrate component (100) along a vertical direction.

2. The semiconductor package according to claim 1, wherein said first surface (S₁), said second surface (S₂), and said sidewall surface (SW) of said substrate component (100) are not covered with an encapsulant.

3. The semiconductor package according to claim 1 or 2, wherein a gap (501) is disposed between said RDL structure (130) and said substrate component (100).

4. The semiconductor package according to claim 3, wherein said gap (501) has a standoff height h₃ that is smaller than 100 µm.

5. The semiconductor package according to claim 3 or 4, wherein said gap (501) is filled with an underfill (114) and said first connecting elements (112) are surrounded by the underfill (114).

6. The semiconductor package according to claim 5, wherein said underfill (114) comprises a non-conductive paste or a non-conductive film.

7. The semiconductor package according to claim 3 or 4, wherein said gap (501) is not filled with an underfill and said first connecting elements (112) are at least partially exposed.

8. The semiconductor package according to any one of claims 1 to 7, wherein said RDL structure (130) comprises dielectric layers (131), traces (132) in said dielectric layers (131), bonding pads (134) at a substrate-side surface of said RDL structure (130) for connecting with said substrate component (100), and re-distributed bonding pads (RBP) disposed at a chip-side surface of said RDL structure (130) for connecting with said at least one integrated circuit die (300);
wherein preferably said first connecting elements (112) are directly connected to said bonding pads (134), respectively.

9. The semiconductor package according to any one of claims 1 to 8, wherein said RDL structure (130) has an RDL pitch of line/space, in the following also referred to as L/S, ≤ 2/2 µm.

## Patentansprüche

1. Halbleitergehäuse (40; 41), umfassend:
eine Substratkomponente (100), umfassend eine erste Oberfläche (S₁), eine zweite Oberfläche (S₂) gegenüber der ersten Oberfläche (S₁) und eine Seitenwandoberfläche (SW), die sich zwischen der ersten Oberfläche (S₁) und der zweiten Oberfläche (S₂) erstreckt;
eine Umverteilungsschicht-, im Folgenden auch als RDL bezeichnet, Struktur (130), die auf der ersten Oberfläche (S₁) angeordnet ist und durch erste Verbindungselemente (112), die Löthöcker oder Kugeln umfassen, elektrisch mit der ersten Oberfläche (S₁) verbunden ist;
eine Vielzahl von Kugelgitterarray-, im Folgenden auch als BGA bezeichnet, Kugeln (110), die auf der zweiten Oberfläche (S₂) der Substratkomponente (100) montiert sind; und
mindestens einen integrierten Schaltungschip (300), der durch zweite Verbindungselemente (310) auf der RDL-Struktur (130) montiert ist;
**dadurch gekennzeichnet, dass**
eine Seitenwandoberfläche der RDL-Struktur (130) entlang einer vertikalen Richtung mit der Seitenwandoberfläche (SW) der Substratkomponente (100) ausgerichtet ist.

2. Halbleitergehäuse nach Anspruch 1, wobei die erste Oberfläche (S₁), die zweite Oberfläche (S₂) und die Seitenwandoberfläche (SW) der Substratkomponente (100) nicht mit einem Verkapselungsmittel bedeckt sind.

3. Halbleitergehäuse nach Anspruch 1 oder 2, wobei ein Spalt (501) zwischen der RDL-Struktur (130) und der Substratkomponente (100) angeordnet ist.

4. Halbleitergehäuse nach Anspruch 3, wobei der Spalt (501) eine Abstandshöhe h₃ aufweist, die kleiner als 100 µm ist.

5. Halbleitergehäuse nach Anspruch 3 oder 4, wobei der Spalt (501) mit einer Unterfüllung (114) gefüllt ist und die ersten Verbindungselemente (112) von der Unterfüllung (114) umgeben sind.

6. Halbleitergehäuse nach Anspruch 5, wobei die Unterfüllung (114) eine nichtleitende Paste oder einen nichtleitenden Film umfasst.

7. Halbleitergehäuse nach Anspruch 3 oder 4, wobei der Spalt (501) nicht mit einer Unterfüllung gefüllt ist und die ersten Verbindungselemente (112) zumindest teilweise freiliegen.

8. Halbleitergehäuse nach einem der Ansprüche 1 bis 7, wobei die RDL-Struktur (130) dielektrische Schichten (131), Leiterbahnen (132) in den dielektrischen Schichten (131), Bondpads (134) an einer substratseitigen Oberfläche der RDL-Struktur (130) zum Verbinden mit der Substratkomponente (100) und umverteilte Bondpads (RBP), die an einer chipseitigen Oberfläche der RDL-Struktur (130) zum Verbinden mit dem mindestens einen integrierten Schaltungschip (300) angeordnet sind, umfasst;
wobei vorzugsweise die ersten Verbindungselemente (112) jeweils direkt mit den Bondpads (134) verbunden sind.

9. Halbleitergehäuse nach einem der Ansprüche 1 bis 8, wobei die RDL-Struktur (130) einen RDL-Abstand von Linie/Raum, im Folgenden auch als L/S bezeichnet, ≤ 2/2 µm aufweist.

## Revendications

1. Boîtier semi-conducteur (40 ; 41), comprenant :
un composant de substrat (100) comprenant une première surface (S₁), une seconde surface (S₂) opposée à ladite première surface (S₁), et une surface de paroi latérale (SW) s'étendant entre ladite première surface (S₁) et ladite seconde surface (S₂) ;
une structure de couche de redistribution, ci-après également appelée RDL, (130) disposée sur ladite première surface (S₁) et connectée électriquement à ladite première surface (S₁) par l'intermédiaire de premiers éléments de connexion (112) comprenant des perles ou des billes de soudure ;
une pluralité de billes de réseau de grille de billes, ci-après également appelées BGA, (110) montées sur ladite seconde surface (S₂) dudit composant de substrat (100) ; et
au moins une puce de circuit intégré (300) montée sur ladite structure RDL (130) par l'intermédiaire de seconds éléments de connexion (310) ;
**caractérisé en ce que**
une surface de paroi latérale de ladite structure RDL (130) est alignée avec ladite surface de paroi latérale (SW) dudit composant de substrat (100) le long d'une direction verticale.

2. Boîtier semi-conducteur selon la revendication 1, dans lequel ladite première surface (S₁), ladite seconde surface (S₂), et ladite surface de paroi latérale (SW) dudit composant de substrat (100) ne sont pas recouvertes d'un agent d'encapsulation.

3. Boîtier semi-conducteur selon la revendication 1 ou 2, dans lequel un espace (501) est disposé entre ladite structure RDL (130) et ledit composant de substrat (100).

4. Boîtier semi-conducteur selon la revendication 3, dans lequel ledit espace (501) a une hauteur d'espacement h₃ qui est inférieure à 100 µm.

5. Boîtier semi-conducteur selon la revendication 3 ou 4, dans lequel ledit espace (501) est rempli d'un sous-remplissage (114) et lesdits premiers éléments de connexion (112) sont entourés par le sous-remplissage (114).

6. Boîtier semi-conducteur selon la revendication 5, dans lequel ledit sous-remplissage (114) comprend une pâte non conductrice ou un film non conducteur.

7. Boîtier semi-conducteur selon la revendication 3 ou 4, dans lequel ledit espace (501) n'est pas rempli d'un sous-remplissage et lesdits premiers éléments de connexion (112) sont au moins partiellement exposés.

8. Boîtier semi-conducteur selon l'une quelconque des revendications 1 à 7, dans lequel ladite structure RDL (130) comprend des couches diélectriques (131), des traces (132) dans lesdites couches diélectriques (131), des plots de connexion (134) au niveau d'une surface côté substrat de ladite structure RDL (130) pour la connexion avec ledit composant de substrat (100), et des plots de connexion redistribués (RBP) disposés au niveau d'une surface côté puce de ladite structure RDL (130) pour la connexion avec ladite au moins une puce de circuit intégré (300) ;
dans lequel de préférence lesdits premiers éléments de connexion (112) sont directement connectés auxdits plots de connexion (134), respectivement.

9. Boîtier semi-conducteur selon l'une quelconque des revendications 1 à 8, dans lequel ladite structure RDL (130) a un pas RDL de ligne/espace, ci-après également appelé L/S, ≤ 2/2 µm.
